(19) Europäisches Patentamt
European Patent Office
Office européen des brevets

(11) **EP 2 254 233 B1**

(12) **EUROPÄISCHE PATENTSCHRIFT**

(45) Veröffentlichungstag und Bekanntmachung des Hinweises auf die Patenterteilung:
**10.08.2011   Patentblatt 2011/32**

(51) Int Cl.:
*H02M 7/49* (2007.01)      *H02M 7/493* (2007.01)

(21) Anmeldenummer: **09157148.9**

(22) Anmeldetag: **02.04.2009**

(54) **Verfahren zum Betrieb einer Umrichterschaltung sowie Vorrichtung zur Durchführung des Verfahrens**

Method for operating an inverter controller and device for carrying out the method

Procédé de fonctionnement d'un circuit convertisseur ainsi que dispositif destiné à l'exécution du procédé

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(43) Veröffentlichungstag der Anmeldung:
**24.11.2010   Patentblatt 2010/47**

(73) Patentinhaber: **ABB Schweiz AG**
**5400 Baden (CH)**

(72) Erfinder: **Winkelnkemper, Manfred**
**CH-5408, Ennetbaden (CH)**

(74) Vertreter: **ABB Patent Attorneys**
**C/o ABB Schweiz AG**
**Intellectual Property (CH-LC/IP)**
**Brown Boveri Strasse 6**
**5400 Baden (CH)**

(56) Entgegenhaltungen:
**DE-A1-102005 040 543      JP-A- 11 206 167**
**US-A- 5 070 440      US-A1- 2004 252 531**

**Beschreibung**

**Technisches Gebiet**

Die Erfindung bezieht sich auf das Gebiet der Leistungselektronik. Sie geht aus von einem Verfahren zum Berieb einer Umrichterschaltung sowie Vorrichtung zur Durchführung des Verfahrens gemäss dem Oberbegriff der unabhängigen Ansprüche.

**Stand der Technik**

Umrichterschaltungen werden heute in einer Vielzahl an Anwendungen eingesetzt. Eine in der Spannung besonders einfach zu skalierende Umrichterschaltung ist in der WO 2007/023064 A1 angegeben. Darin weist die Umrichterschaltung ein erstes und ein zweites Teilumrichtersystem auf, wobei die Teilumrichtersysteme über zwei in Serie geschaltete Induktivitäten seriell miteinander verbunden sind. Der Verbindungspunkt der beiden in Serie geschalteten Induktivitäten bildet einen Ausgangsanschluss beispielsweise für eine elektrische Last. Jedes Teilumrichtersystem umfasst mindestens eine zweipolige Schaltzelle, wobei im Falle mehrerer Schaltzellen eines Teilumrichtersystems diese Schaltzellen seriell miteinander verbunden sind. Jede zweipolige Schaltzelle weist zwei in Serie geschaltete ansteuerbare bidirektionale Leistungshalbleiterschalter mit gesteuerter unidirektionaler Stromführungsrichtung und einen zu der Serienschaltung der Leistungshalbleiterschalter parallel geschalteten kapazitiven Energiespeicher auf.

Für den Betrieb einer Umrichterschaltung nach der WO 2007/023064 A1 ist eine gängige Vorrichtung, wie sie in Fig. 1 gezeigt ist, vorgesehen, welche eine erste Ansteuerschaltung zur Erzeugung eines Ansteuersignals zur Ansteuerung der Leistungshalbleiterschalter der Schaltzellen des ersten Teilumrichtersystems und eine zweite Ansteuerschaltung zur Erzeugung eines weiteren Ansteuersignals zur Ansteuerung der Leistungshalbleiterschalter der Schaltzellen des zweiten Teilumrichtersystems aufweist.

Typischerweise wird die Umrichterschaltung nach der WO 2007/023064 A1 derart betrieben, dass am Ausgangsanschluss eine reine Wechselspannung und ein reiner Wechselstrom bereitgestellt werden. Die Auslegung der kapazitiven Energiespeicher der Schaltzellen erfolgt derart, dass die Spannungswelligkeit an den kapazitiven Energiespeichern für einen gegeben Maximalstrom am Ausgangsanschluss und eine gegebene Frequenz dieses Stromes innerhalb einer vorgegeben Schwankungsbreite bleibt. Wird eine kleine Frequenz gewünscht als die, die bei der Dimensionierung zugrunde gelegt wurde, dann steigt die Spannungswelligkeit an. Soll ein Gleichstrom oder ein Wechselstrom mit Gleichstromanteil am Ausgangsanschluss bereitgestellt werden, dann steigt die Spannungswelligkeit nahezu ins Unendliche. Die kapazitiven Energiespeicher müssten in diesem Fall entweder von extern gespeist werden oder unendlich gross gewählt werden, damit sie beim Betrieb mit Gleichstrom oder Gleichstromanteil am Ausgangsanschluss nicht vollständig entladen bzw. beliebig überladen werden.

Ein Verfahren zum Betrieb einer Umrichterschaltung nach der WO 2007/023064 A1, welches eine vom gewünschten Strom am Ausgangsanschluss, d.h. von dessen Frequenz, unabhängige Dimensionierung der kapazitiven Energiespeicher ermöglicht, ist derzeit nicht bekannt. Im Dokument US 5,070,440 A1 ist eine Umrichterschaltung mit einem ersten und einem zweiten Teilumrichtersystem beschrieben. Das Verfahren zum Betrieb der Umrichterschaltung ermöglicht die Reduktion von den Oberschwingungen. **Darstellung der Erfindung**

Aufgabe der Erfindung ist es deshalb, ein Verfahren zum Betrieb einer Umrichterschaltung anzugeben, mittels welchem eine vom gewünschten Strom am Ausgangsanschluss der Umrichterschaltung, d.h. von dessen Frequenz, unabhängige Dimensionierung der kapazitiven Energiespeicher der Umrichterschaltung ermöglicht. Ferner ist es eine Aufgabe der Erfindung, eine Vorrichtung anzugeben, mit der das erfindungsgemässe Verfahren in besonders einfacher Weise durchgeführt werden kann.

Diese Aufgaben werden durch die Merkmale des Anspruchs 1 bzw. des Anspruchs 10 gelöst. In den abhängigen Ansprüchen sind vorteilhafte Weiterbildungen der Erfindung angegeben.

Die Umrichterschaltung weist ein erstes und ein zweites Teilumrichtersystem auf, wobei die Teilumrichtersysteme über zwei in Serie geschaltete Induktivitäten seriell miteinander verbunden sind. Der Verbindungspunkt der beiden in Serie geschalteten Induktivitäten bildet einen Ausgangsanschluss. Jedes Teilumrichtersystem umfasst mindestens eine zweipolige Schaltzelle, und jede Schaltzelle weist zwei in Serie geschaltete ansteuerbare bidirektionale Leistungshalbleiterschalter mit gesteuerter unidirektionaler Stromführungsrichtung und einen zu der Serienschaltung der Leistungshalbleiterschalter parallel geschalteten kapazitiven Energiespeicher auf. Vorzugsweise entspricht die Anzahl Schaltzellen des ersten Teilumrichtersystems der Anzahl Schaltzellen des zweiten Teilumrichtersystems. Verfahrensmässig werden die Leistungshalbleiterschalter der Schaltzellen des ersten Teilumrichtersystems mittels eines Ansteuersignals und die Leistungshalbleiterschalter der Schaltzellen des zweiten Teilumrichtersystems mittels eines weiteren Ansteuersignals angesteuert. Erfindungsgemäss wird nun das Ansteuersignal aus einem Spannungsschwingungssignal über den Induktivitäten und einer Schaltfunktionen für die Leistungshalbleiterschalter der Schaltzellen des ersten Teilumrichtersystems gebildet, und das weitere Ansteuersignal wird aus dem Spannungsschwingungssignal über den Induktivitäten und einer Schaltfunktionen für die Leistungshalbleiterschalter der Schaltzellen des zweiten Teilumrichtersystems gebildet, wobei die Schaltfunktionen mittels eines Spannungsschwingungssignals bezüglich der Spannung am Ausgangsanschluss und einem wählbaren Referenzsignal, insbesondere gleichzeitig, gebildet werden. Mittels den eingeprägten Schwingungen, d.h. durch das Spannungsschwingungssignal über den Induktivitäten für die Erzeugung des Ansteuersignals und des weiteren Ansteuersignals und durch das Spannungsschwingungssignals bezüglich der Spannung am Ausgangsanschluss zur Erzeugung der Schaltfunktionen, kann vorteilhaft erreicht werden, dass die Spannungswelligkeit an den kapazitiven Energiespeichern bei einem gewünschten Strom am Ausgangsanschluss der Umrichterschaltung signifikant verringert werden kann, wodurch die Auslegung bzw. Dimensionierung der kapazitiven Energiespeicher lediglich bezüglich der nun verringerten Spannungswelligkeit erfolgen muss und damit unabhängig von dem gewünschten Ausgangsstrom ist.

Die erfindungsgemässe Vorrichtung zur Durchführung des Verfahrens zum Betrieb der Umrichterschaltung weist eine der Erzeugung des Ansteuersignals dienende erste Ansteuerschaltung auf, welche erste Ansteuerschaltung mit den Leistungshalbleiterschaltern der Schaltzellen des ersten Teilumrichtersystems verbunden ist. Ferner weist die Vorrichtung eine der Erzeugung des weiteren Ansteuersignals dienende zweite Ansteuerschaltung auf, welche zweite Ansteuerschaltung mit den Leistungshalbleiterschaltern der Schaltzellen des zweiten Teilumrichtersystems verbunden ist. Nach der Erfindung ist nun der ersten Ansteuerschaltung zur Bildung des Ansteuersignals das Spannungsschwingungssignal über den Induktivitäten und die Schaltfunktion für die Leistungshalbleiterschalter der Schaltzellen des ersten Teilumrichtersystems zugeführt. Der zweiten Ansteuerschaltung zur Bildung des weiteren Ansteuersignals ist das Spannungsschwingungssignal über den Induktivitäten und die Schaltfunktion für die Leistungshalbleiterschalter der Schaltzellen des zweiten Teilumrichtersystems zugeführt. Darüber hinaus ist eine erste Berechnungseinheit zur Berechnung der Schaltfunktionen aus einem Spannungsschwingungssignal bezüglich der Spannung am Ausgangsanschluss und einem wählbaren Referenzsignal vorgesehen. Die erfindungsgemässe Vorrichtung zur Durchführung des Verfahrens zum Betrieb der Umrichterschaltung ist somit sehr einfach und kostengünstig realisierbar, da der Schaltungsaufwand äusserst gering gehalten werden kann und zudem nur eine geringe Anzahl an Bauelementen für den Aufbau benötigt wird. Mittels dieser Vorrichtung ist das erfindungsgemässe Verfahren somit besonders einfach durchführbar.

Diese und weitere Aufgaben, Vorteile und Merkmale der vorliegenden Erfindung werden aus der nachfolgenden detaillierten Beschreibung bevorzugter Ausführungsformen der Erfindung in Verbindung mit der Zeichnung offensichtlich.

## Kurze Beschreibung der Zeichnungen

Es zeigen:

Fig. 1     eine Ausführungsform einer Vorrichtung zur Durchführung eines Verfahrens zum Betrieb einer Umrichterschaltung nach dem Stand der Technik,

Fig. 2     eine Ausführungsform einer erfindungsgemässen Vorrichtung zur Durchfüh- rung des erfindungsgemässen Verfahrens zum Betrieb einer Umrichterschal- tung,

Fig. 3     ein zeitlicher Verlauf eines Stromes am Ausgangsanschluss der Umrichter- schaltung,

Fig. 4     ein zeitlicher Verlauf einer Spannung am Ausgangsanschluss der Umrichter- schaltung, und

Fig. 5     ein zeitlicher Verlauf des Stromes durch das erste Teilumrichtersystem und des Stromes durch das zweite Teilumrichtersystem.

Die in der Zeichnung verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen. Die beschriebenen Ausführungsformen stehen beispielhaft für den Erfindungsgegenstand und haben keine beschränkende Wirkung.

## Wege zur Ausführung der Erfindung

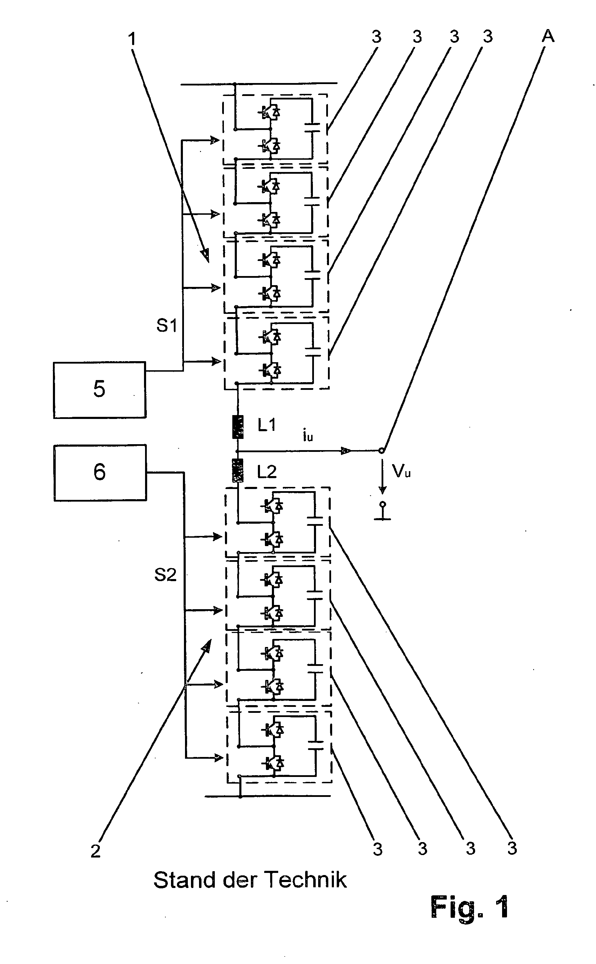

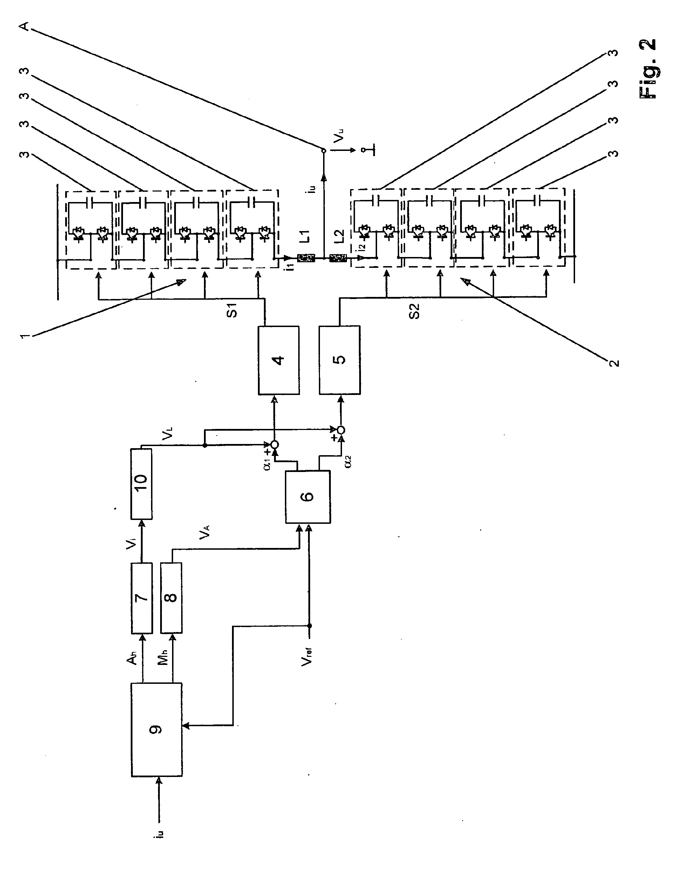

In Fig. 1 ist, wie eingangs bereits erwähnt, eine Ausführungsform einer Vorrichtung zur Durchführung eines Verfahrens zum Betrieb einer Umrichterschaltung nach dem Stand der Technik dargestellt. Fig. 2 zeigt eine Ausführungsform einer erfindungsgemässen Vorrichtung zur Durchführung des erfindungsgemässen Verfahrens zum Betrieb einer Umrichterschaltung. Die Umrichterschaltung gemäss Fig. 2 weist ein erstes und ein zweites Teilumrichtersystem 1, 2 auf, wobei die Teilumrichtersysteme 1, 2 über zwei in Serie geschaltete Induktivitäten L1, L2 seriell miteinander verbunden sind. Der Verbindungspunkt der beiden in Serie geschalteten Induktivitäten L1, L2 bildet einen Ausgangsanschluss A. Jedes Teilumrichtersystem 1, 2 umfasst allgemein mindestens eine zweipolige Schaltzelle 3. Im Falle mehrerer Schaltzellen 3 eines Teilumrichtersystems 1, 2 sind diese Schaltzellen 3 seriell miteinander verbunden, wie in Fig. 2 gezeigt. Jede Schaltzelle 3 weist zwei in Serie geschaltete ansteuerbare bidirektionale Leistungshalbleiterschalter mit gesteuerter unidirektionaler Stromführungsrichtung und einen zu der Serienschaltung der Leistungshalbleiterschalter parallel geschalteten kapazitiven Energiespeicher auf. Der ansteuerbare Leistungshalbleiterschalter ist insbesondere als Abschaltthyristor (GTO - Gate Turn-Off Thyristor) oder als integrierter Thyristor mit kommutierter Ansteuerelektrode (IGCT - Integrated Gate Commutated Thyristor) mit jeweils einer antiparallel geschalteten Diode ausgebildet. Es ist aber auch denkbar, einen ansteuerbaren Leistungshalbleiterschalter beispielsweise als Leistungs-MOSFET mit zusätzlich antiparallel geschalteter Diode oder als Bipolartransistor mit isoliert angeordneter Gateelektrode (IGBT) mit zusätzlich antiparallel geschalteter Diode auszubilden. Vorzugsweise entspricht die Anzahl Schaltzellen 3 des ersten Teilumrichtersystems 1 der Anzahl Schaltzellen 3 des zweiten Teilumrichtersystems 2.

Verfahrensmässig werden die Leistungshalbleiterschalter der Schaltzellen 3 des ersten Teilumrichtersystems 1 mittels eines Ansteuersignals S1 und die Leistungshalbleiterschalter der Schaltzellen 3 des zweiten Teilumrichtersystems 2 mittels eines weiteren Ansteuersignals S2 angesteuert. Das Ansteuersignal S1 der Schaltzellen 3 des ersten Teilumrichtersystems 1 und das Ansteuersignal S2 der Schaltzellen 3 des zweiten Teilumrichtersystems 2 ist für jede Schaltzelle 3 vorzugsweise zeitlich versetzt, so dass jede Schaltzelle 3 vorteilhaft zeitlich versetzt angesteuert werden kann. Erfindungsgemäss wird nun das Ansteuersignal S1 aus einem Spannungsschwingungssignal $V_L$ über den Induktivitäten L1, L2 und einer Schaltfunktion $\alpha_1$ für die Leistungshalbleiterschalter der Schaltzellen 3 des ersten Teilumrichtersystems 1, insbesondere aus der Summe beider Grössen, gebildet, und das weitere Ansteuersignal S2 wird aus dem Spannungsschwingungssignal $V_L$ über den Induktivitäten L1, L2 und einer Schaltfunktionen $\alpha_2$ für die Leistungshalbleiterschalter der Schaltzellen 3 des zweiten Teilumrichtersystems 2, insbesondere aus der Summe beider Grössen, gebildet, wobei die Schaltfunktionen $\alpha_1$, $\alpha_2$ mittels eines Spannungsschwingungssignals $V_A$ bezüglich der Spannung $V_u$ am Ausgangsanschluss A und einem wählbaren Referenzsignal $V_{ref}$, insbesondere gleichzeitig, gebildet werden. Vorzugsweise wird als Referenzsignal $V_{ref}$ ein Referenzspannungssignal bezüglich der Spannung $V_u$ am Ausgangsanschluss A gewählt, welches beispielsweise durch Ausregelung des Istwertes des Stromes $i_u$ am Ausgangsanschluss A auf einen Sollwert gebildet wird.

Mittels den eingeprägten Schwingungen, d.h. durch das Spannungsschwingungssignal $V_L$ über den Induktivitäten L1, L2 für die Erzeugung des Ansteuersignals S1 und des weiteren Ansteuersignals S2 und durch das Spannungsschwingungssignal $V_A$ bezüglich der Spannung $V_u$ am Ausgangsanschluss A zur Erzeugung der Schaltfunktionen $\alpha_1$, $\alpha_2$, kann vorteilhaft erreicht werden, dass die Spannungswelligkeit an den kapazitiven Energiespeichern bei einem gewünschten Strom $i_u$ am Ausgangsanschluss A der Umrichterschaltung signifikant verringert werden kann, wodurch die Auslegung bzw. Dimensionierung der kapazitiven Energiespeicher lediglich bezüglich der nun verringerten Spannungswelligkeit erfolgen muss und damit unabhängig von dem gewünschten Ausgangsstrom $i_u$ ist.

Nach der Erfindung wird die Schaltfunktion $\alpha_1$ für die Leistungshalbleiterschalter der Schaltzellen 3 des ersten Teilumrichtersystems 1 aus dem Spannungsschwingungssignal $V_A$ bezüglich der Spannung $V_u$ am Ausgangsanschluss A und dem wählbaren Referenzsignal $V_{ref}$ nach folgender Formel gebildet:

$$\alpha_1 = \frac{1}{2}(1 - V_{ref} - V_A) \qquad [1]$$

Desweiteren wird Schaltfunktion $\alpha_2$ für die Leistungshalbleiterschalter der Schaltzellen 3 des zweiten Teilumrichtersystems 2 aus dem Spannungsschwingungssignal $V_A$ bezüglich der Spannung $V_u$ am Ausgangsanschluss A und dem wählbaren Referenzsignal $V_{ref}$ nach folgender Formel gebildet:

$$\alpha_2 = \frac{1}{2}(1 + V_{ref} + V_A) \qquad [2]$$

Nach der Erfindung wird das Spannungsschwingungssignal $V_L$ über den Induktivitäten L1, L2 aus einem Stromschwingungssignal $V_i$ der Teilumrichtersysteme 1, 2 gebildet, wie nachfolgende Formel verdeutlicht:

$$V_L = V_i \cdot (j\omega(L1 + L2)) \qquad [3]$$

Das Stromschwingungssignal $V_i$ der Teilumrichtersysteme 1, 2 wird vorzugsweise wiederum aus einem Stromschwingungssignalamplitudenwert $A_h$ gebildet, insbesondere durch Multiplikation des Stromschwingungssignalamplitudenwertes $A_h$ mit einer Schwingung frei wählbarer Frequenz $\omega$ und Phasenverschiebung $\varphi$, wie nachfolgende Formel verdeutlicht:

$$V_i = A_h \cdot \cos(\omega t + \varphi) \qquad [4]$$

Der Stromschwingungssignalamplitudenwert $A_h$ wird allgemein aus dem Stromistwert $i_u$ am Ausgangsanschluss A, insbesondere aus dem Gleichstromanteil $I_0$ des Stromes $i_u$ am Ausgangsanschluss A, welcher Stromistwert $i_u$ beispielsweise gemessen wird, und dem Referenzsignal $V_{ref}$ gebildet. Zur Bildung des Stromschwingungssignalamplitudenwertes $A_h$ wird der folgende Zusammenhang nach der Formel [5.1] genutzt:

$$\frac{1}{2}I_0 \cdot M_h{}^2 + A_h \cdot M_h \cdot \cos(\Delta\varphi) - (1 + V_{ref}) \cdot (1 - V_{ref}) \cdot I_0 \cong 0 \quad [5.1]$$

und beispielsweise nach Formel [5.2]

$$A_h \cong M_h \qquad [5.2]$$

gesetzt, wobei $\Delta\varphi$ allgemein der Phasenunterschied zwischen den eingeprägten Schwingungen und der Spannung $V_u$ am Ausgangsanschluss A ist. Es sei darauf hingewiesen, dass das Verhältnis von $A_h$ zu $M_h$ in Formel [5.2] nur beispielhaft gewählt ist, d.h. das Verhältnis von $A_h$ zu $M_h$ kann allgemein frei gewählt werden. Zur Bestimmung des Stromschwingungssignalamplitudenwertes $A_h$ muss Formel [5.1] somit lediglich noch nach dem Stromschwingungssignalamplitudenwert $A_h$ aufgelöst werden.

Ferner wird das Spannungsschwingungssignal $V_A$ bezüglich der Spannung $V_u$ am Ausgangsanschluss A allgemein aus einem Spannungsschwingungssignalamplitudenwert $M_h$ gebildet, vorzugsweise durch Multiplikation des Spannungsschwingungssignalamplitudenwertes $M_h$ mit einer Schwingung frei wählbarer Frequenz w und Phasenverschiebung $\varphi$, wie nachfolgende Formel verdeutlicht:

$$V_A = M_h \cdot \cos(\omega t + \varphi) \qquad [6]$$

Allgemein wird der Spannungsschwingungssignalamplitudenwert $M_h$ aus dem Stromistwert $i_u$ am Ausgangsanschluss A und dem Referenzsignal $V_{ref}$ gebildet, wobei vorteilhaft auf Formel [5.1] und [5.2] zurückgegriffen werden kann und zur Bestimmung des Spannungsschwingungssignalamplitudenwertes $M_h$ Formel [5.1] nur noch nach dem Spannungsschwingungssignalamplitudenwert $M_h$ aufgelöst werden muss.

Vorzugsweise weist das Stromschwingungssignal $V_i$ der Teilumrichtersysteme 1, 2, das Spannungsschwingungssignal $V_L$ über den Induktivitäten L1, L2 und das Spannungsschwingungssignal $V_A$ bezüglich der Spannung $V_u$ am Ausgangsanschluss A dieselbe Frequenz w auf. Desweiteren weist das Stromschwingungssignal $V_i$ der Teilumrichtersysteme 1, 2, das Spannungsschwingungssignal $V_L$ über den Induktivitäten L1, L2 und das Spannungsschwingungssignal $V_A$ bezüglich der Spannung $V_u$ am Ausgangsanschluss A vorteilhaft dieselbe Phasenverschiebung $\varphi$ auf, wobei die dieselbe Phasenverschiebung $\varphi$ nicht zwingend notwendig ist.

Nach dem erfindungsgemässen Verfahren ist es nun vorteilhaft möglich, am Ausgangsanschluss A einen Strom $i_u$ mit einem Gleichanteil sowie mit einem Wechselanteil der Frequenz $\omega$, der von den vorstehend genannten eingeprägten Schwingungen herrührt, zu erzeugen, wobei nur die eingeprägten Schwingungen die Spannungswelligkeit an den kapazitiven Energiespeichern der Schaltzellen 3 beeinflussen und die Spannungswelligkeit damit klein gehalten werden kann. Die damit einhergehend Auslegung bzw. Dimensionierung der kapazitiven Energiespeicher kann nun vorteilhaft nur bezüglich dieser geringen Spannungswelligkeit erfolgen, d.h. unabhängig von dem gewünschten Ausgangsstrom $i_u$. Der Strom $i_u$ am Ausgangsanschluss A ergibt sich demnach zu

$$i_u(t) = I_0 + \hat{i}_u \cdot \cos(\omega t + \varphi) \qquad\qquad [7],$$

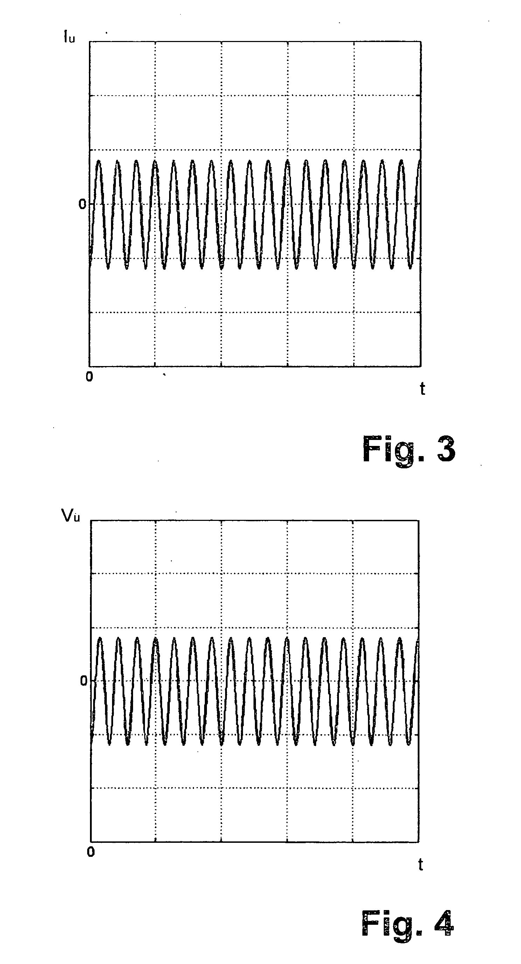

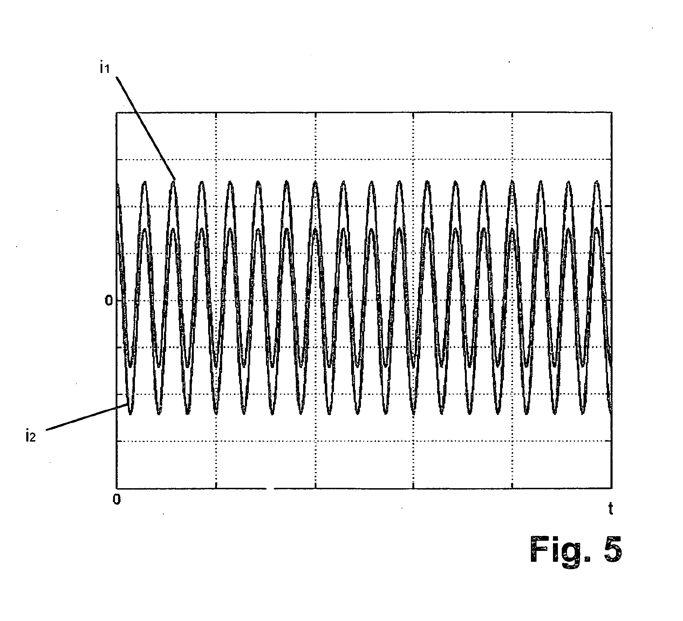

wobei $I_0$ der besagte Gleichanteil und $\hat{i}_U$ die Amplitude des besagten Wechselanteils ist. Zur Veranschaulichung ist in Fig. 3 ein zeitlicher Verlauf eines Stromes $i_u$. am Ausgangsanschluss der Umrichterschaltung dargestellt. Darüber hinaus zeigt Fig. 4 einen zeitlichen Verlauf einer Spannung $V_u$ am Ausgangsanschluss A der Umrichterschaltung. In Fig. 5 ist schliesslich ein zeitlicher Verlauf des Stromes $i_1$ durch das erste Teilumrichtersystem 1 und des Stromes $i_2$ durch das zweite Teilumrichtersystem 2 gezeigt, wobei in beiden Strömen $i_1$, $i_2$ ebenfalls Gleichanteil und ein Wechselanteil der Frequenz w, herrührend von den vorstehend genannten eingeprägten Schwingungen, enthalten ist. Der Vollständigkeit halber sei erwähnt, dass die Ströme in den kapazitiven Energiespeichern keinen Gleichanteil und ebenfalls Wechselanteile der Frequenz w aber auch der zweifachen Frequenz w der vorstehend genannten eingeprägten Schwingungen aufweisen.

In einem Mehrphasensystem, beispielsweise in einem Dreiphasensystem mit drei Umrichterschaltungen, erscheinen die eingeprägten Schwingungen, falls diese bezüglich ihren Phasenverschiebungen gleich gewählt sind, an einer an die Phasenabschlüsse A angeschlossenen mehrphasigen Last als Gleichtaktspannung. Zusätzliche Stromschwingungen werden nicht erzeugt. Dieses Verfahren wird z.B. bei der Übermodulation eingesetzt. Im Gegensatz zur Übermodulation ist hier die Frequenz und Phasenlage der Gleichtaktspannung beliebig. Der dann mehrphasige Ausgangsstrom $i_0$ ist ein reiner Gleichstrom, d.h. dieser weist keine Wechselanteile auf.

Soll der Strom $i_u$ am Ausgangsanschluss A einen gewünschten Wechselanteil $\hat{i}_u.\cos(\omega_u t + \varphi_u)$ der Frequenz $\omega_u$ und eine gewünschte Phasenverschiebung $\varphi_u$ aufweisen, so ändert sich Formel [5.1] wie folgt:

$$\frac{1}{2}\hat{i}_u \cdot \cos(\omega_u t + \varphi_u) \cdot M_h{}^2 + A_h \cdot M_h \cos(\Delta\varphi) - (1 + V_{ref}) \cdot (1 - V_{ref}) \cdot \hat{i}_u \cdot \cos(\omega_u t + \varphi_u) \equiv 0 \quad [8],$$

wobei zur Bestimmung des Stromschwingungssignalamplitudenwertes $A_h$ dann wieder auf Formel [5.2] zurückgegriffen werden kann und der Stromschwingungssignalamplitudenwert $A_h$ und der Spannungsschwingüngssignalamplitudenwert $M_h$ wie vorstehend bereits beschrieben aus Formel [8] und Formel [5.2] bestimmt werden kann. Es ergibt sich der Strom $i_u$ am Ausgangsanschluss A dann in gewünschter Weise zu

$$i_u(t) = \hat{i}_u \cdot \cos(\omega_u t + \varphi_u) + \hat{i}_h \cdot \cos(\omega t + \varphi) \qquad [9],$$

wobei $\hat{i}_n$ ein angenommener Stromamplitudenwert ist.

Die erfindungsgemässe Vorrichtung nach Fig. 1 weist eine der Erzeugung des Ansteuersignals S1 dienende erste Ansteuerschaltung 4 auf, welche erste Ansteuerschaltung 4 mit den Leistungshalbleiterschaltern der Schaltzellen 3 des ersten Teilumrichtersystems 1 verbunden ist. Ferner ist eine der Erzeugung des weiteren Ansteuersignals S2 dienende zweite Ansteuerschaltung 5 vorgesehen, welche zweite Ansteuerschaltung 5 mit den Leistungshalbleiterschaltern der Schaltzellen 3 des zweiten Teilumrichtersystems 2 verbunden ist. Erfindungsgemäss ist der ersten Ansteuerschaltung 4 zur Bildung des Ansteuersignals S1 die Summe aus dem Spannungsschwingungssignal $V_L$ über den Induktivitäten L1, L2 und der Schaltfunktion $\alpha_1$ für die Leistungshalbleiterschalter der Schaltzellen 3 des ersten Teilumrichtersystems 1 zugeführt. Der zweiten Ansteuerschaltung 5 zur Bildung des weiteren Ansteuersignals S2 ist die Summe aus dem Spannungsschwingungssignal $V_L$ über den Induktivitäten L1, L2 und der Schaltfunktion $\alpha_2$ für die Leistungshalbleiterschalter der Schaltzellen 3 des zweiten Teilumrichtersystems 2 zugeführt. Zur Bildung des Ansteuersignals S1 und des weiteren Ansteuersignals S2 dient beispielsweise jeweils eine Zuordnungstabelle (look-up table) in der ersten und zweiten Ansteuerschaltung 4, 5, bei welcher der Schaltfunktion $\alpha_1$ entsprechende Ansteuersignale S1 und bei welcher der Schaltfunktion $\alpha_2$ entsprechende weiter Ansteuersignale S2 fest zugeordnet sind, oder beispielsweise jeweils ein Modulator, welcher auf einem Verfahren der Pulsweitenmodulation basiert. Weiterhin ist eine erste Berechnungseinheit 6 zur Bildung der Schaltfunktionen $\alpha_1$, $\alpha_2$ mittels Berechnung gemäss Formel [1] und [2] aus dem Spannungsschwingungssignal $V_A$ bezüglich der Spannung $V_u$ am Ausgangsanschluss A und einem wählbaren Referenzsignal $V_{ref}$ vorgesehen.

Gemäss Fig. 2 ist eine zweite Berechnungseinheit 10 zur Bildung des Spannungsschwingungssignals $V_L$ über den Induktivitäten L1, L2 aus einem Stromschwingungssignal $V_i$ der Teilumrichtersysteme 1, 2 vorgesehen, wobei die zweite Berechnungseinheit 10 die Bildung des Spannungsschwingungssignals $V_L$ über den Induktivitäten L1, L2 durch Berechnung mittels der Formel [3] durchführt.

Desweiteren ist eine dritte Berechnungseinheit (7) zur Bildung des Stromschwingungssignals $V_i$ der Teilum-

richtersysteme 1, 2 aus einem Stromschwingungssignalamplitudenwert $A_h$ vorgesehen, die die Bildung des Stromschwingungssignals $V_i$ der Teilumrichtersysteme 1, 2 mittels Berechnung nach der Formel [4] ausführt.

Darüber hinaus ist eine vierte Berechnungseinheit 9 zur Bildung des Stromschwingungssignalamplitudenwertes $A_h$ aus dem Stromistwert $i_u$ am Ausgangsanschluss A und dem Referenzsignal $V_{ref}$ vorgesehen, wobei die vierte Berechnungseinheit 9 die Bildung des Stromschwingungssignalamplitudenwertes $A_h$ durch Berechnung gemäss den Formeln [5.1] und [5.2] bzw. gemäss den Formeln [8] und [5.2] durchführt.

Eine vorgesehene fünfte Berechnungseinheit 8 dient der Bildung des Spannungsschwingungssignals $V_A$ bezüglich der Spannung $V_u$ am Ausgangsanschluss A aus einem Spannungsschwingungssignalamplitudenwert $M_h$, wobei die fünfte Berechnungseinheit 8 die der Bildung des Spannungsschwingungssignals $V_A$ bezüglich der Spannung $V_u$ am Ausgangsanschluss A durch Berechnung nach Formel [6] ausführt.

Die bereits erwähnte vierte Berechnungseinheit 9 dient ebenfalls zur Bildung des Spannungsschwingungssignalamplitudenwertes $M_h$ aus dem Stromistwert $i_u$ am Ausgangsanschluss A und dem Referenzsignal $V_{ref}$, wobei die vierte Berechnungseinheit 9 die Bildung des Spannungsschwingungssignalamplitudenwertes $M_h$ durch Berechnung nach den Formeln [5.1] und [5.2] bzw. gemäss den Formeln [8] und [5.2] durchführt.

Insgesamt konnte gezeigt werden, dass die, insbesondere in Fig. 2 gezeigte, erfindungsgemässe Vorrichtung zur Durchführung des erfindungsgemässen Verfahrens zum Betrieb der Umrichterschaltung sehr einfach und kostengünstig realisiert werden kann, da der Schaltungsaufwand äusserst gering ist und zudem nur eine geringe Anzahl an Bauelementen für den Aufbau benötigt wird. Somit ist mit dieser Vorrichtung das erfindungsgemässe Verfahren besonders einfach durchführbar.

**Bezugszeichenliste**

1      erstes Teilumrichtersystem
2      zweites Teilumrichtersystem
3      Schaltzelle
4      erste Ansteuerschaltung
5      zweite Ansteuerschaltung
6      erste Berechnungseinheit
7      dritte Berechnungseinheit
8      fünfte Berechnungseinheit
9      vierte Berechnungseinheit
10     zweite Berechnungseinheit

**Patentansprüche**

1. Verfahren zum Betrieb einer Umrichterschaltung, wobei die Umrichterschaltung ein erstes und ein zweites Teilumrichtersystem (1) aufweist, die Teilumrichtersysteme (2) über zwei in Serie geschaltete Induktivitäten (L1, L2) seriell miteinander verbunden sind, der Verbindungspunkt der beiden in Serie geschalteten Induktivitäten (L1, L2) einen Ausgangsanschluss (A) bildet, jedes Teilumrichtersystem (1, 2) mindestens eine zweipolige Schaltzelle (3) umfasst und jede Schaltzelle (3) zwei in Serie geschaltete ansteuerbare bidirektionale Leistungshalbleiterschalter mit gesteuerter unidirektionaler Stromführungsrichtung und einen zu der Serienschaltung der Leistungshalbleiterschalter parallel geschalteten kapazitiven Energiespeicher aufweist,
bei dem die Leistungshalbleiterschalter der Schaltzellen (3) des ersten Teilumrichtersystems (1) mittels eines Ansteuersignals (S1) und die Leistungshalbleiterschalter der Schaltzellen (3) des zweiten Teilumrichtersystems (2) mittels eines weiteren Ansteuersignals (S2) angesteuert werden,
**dadurch gekennzeichnet,**
**dass** das Ansteuersignal (S1) aus einem Spannungsschwingungssignal ($V_L$) über den Induktivitäten (L1, L2) und einer Schaltfunktionen ($\alpha_1$) für die Leistungshalbleiterschalter der Schaltzellen (3) des ersten Teilumrichtersystems (1) gebildet wird,
**dass** das weitere Ansteuersignal (S2) aus dem Spannungsschwingungssignal ($V_L$) über den Induktivitäten (L1, L2) und einer Schaltfunktionen ($\alpha_2$) für die Leistungshalbleiterschalter der Schaltzellen (3) des zweiten Teilumrichtersystems (2) gebildet wird, und dass die Schaltfunktionen ($\alpha_1$, $\alpha_2$) mittels eines Spannungsschwingungssignals ($V_A$) bezüglich der Spannung ($V_u$) am Ausgangsanschluss (A) und einem wählbaren Referenzsignal ($V_{ref}$) gebildet werden.

2. Verfahren nach Anspruch 1, **dadurch gekennzeichnet, dass** das Spannungsschwingungssignal ($V_L$) über den Induktivitäten (L1, L2) aus einem Stromschwingungssignal ($V_i$) der Teilumrichtersysteme (1, 2) gebildet wird.

3. Verfahren nach Anspruch 2, **dadurch gekennzeichnet, dass** das Stromschwingungssignal ($V_i$) der Teilumrichtersysteme (1, 2) aus einem Stromschwingungssignalamplitudenwert ($A_h$) gebildet wird.

4. Verfahren nach Anspruch 3, **dadurch gekennzeichnet, dass** der Stromschwingungssignalamplitudenwert ($A_h$) aus dem Stromistwert ($i_u$) am Ausgangsanschluss (A) und dem Referenzsignal ($V_{ref}$) gebildet wird.

5. Verfahren nach einem der vorhergehenden Ansprüche 1 bis 4, **dadurch gekennzeichnet, dass** das Spannungsschwingungssignal ($V_A$) bezüglich der Spannung ($V_u$) am Ausgangsanschluss (A) aus einem Spannungsschwingungssignalamplitudenwert ($M_h$) gebildet wird.

6. Verfahren nach Anspruch 5, **dadurch gekennzeichnet, dass** der Spannungsschwingungssignalamplitudenwert ($M_h$) aus dem Stromistwert ($i_u$) am Ausgangsanschluss (A) und dem Referenzsignal ($V_{ref}$) gebildet wird.

7. Verfahren nach Anspruch 2, **dadurch gekennzeichnet, dass** das Stromschwingungssignal ($V_i$) der Teilumrichtersysteme (1, 2), das Spannungsschwingungssignal ($V_L$) über den Induktivitäten (L1, L2) und das Spannungsschwingungssignal ($V_A$) bezüglich der Spannung ($V_u$) am Ausgangsanschluss (A) dieselbe Frequenz aufweist.

8. Verfahren nach Anspruch 2 oder 7, **dadurch gekennzeichnet, dass** das Stromschwingungssignal ($V_i$) der Teilumrichtersysteme (1, 2), das Spannungsschwingungssignal ($V_L$) über den Induktivitäten (L1, L2) und das Spannungsschwingungssignal ($V_A$) bezüglich der Spannung ($V_u$) am Ausgangsanschluss (A) dieselbe Phasenverschiebung aufweist.

9. Verfahren nach einem der vorhergehenden Ansprüche 1 bis 8, **dadurch gekennzeichnet, dass** als Referenzsignal ($V_{ref}$) ein Referenzspannungssignal bezüglich der Spannung ($V_u$) am Ausgangsanschluss (A) gewählt wird.

10. Vorrichtung zur Durchführung eines Verfahrens zum Betrieb einer Umrichterschaltung, wobei die Umrichterschaltung ein erstes und ein zweites Teilumrichtersystem (1) aufweist, die Teilumrichtersysteme (2) über zwei in Serie geschaltete Induktivitäten (L1, L2) seriell miteinander verbunden sind, der Verbindungspunkt der beiden in Serie geschalteten Induktivitäten (L1, L2) einen Ausgangsanschluss (A) bildet, jedes Teilumrichtersystem (1, 2) mindestens eine zweipolige Schaltzelle (3) umfasst und jede Schaltzelle (3) zwei in Serie geschaltete ansteuerbare bidirektionale Leistungshalbleiterschalter mit gesteuerter unidirektionaler Stromführungsrichtung und einen zu der Serienschaltung der Leistungshalbleiterschalter parallel geschalteten kapazitiven Energiespeicher aufweist,
mit einer der Erzeugung eines Ansteuersignals (S1) dienenden ersten Ansteuerschaltung (4), welche erste Ansteuerschaltung (4) mit den Leistungshalbleiterschaltern der Schaltzellen (3) des ersten Teilumrichtersystems (1) verbunden ist, und mit einer der Erzeugung eines weiteren Ansteuersignals (S2) dienenden zweiten Ansteuerschaltung (5), welche zweite Ansteuerschaltung (5) mit den Leistungshalbleiterschaltern der Schaltzellen (3) des zweiten Teilumrichtersystems (2) verbunden ist,
**dadurch gekennzeichnet,**
**dass** der ersten Ansteuerschaltung (4) zur Bildung des Ansteuersignals (S1) ein Spannungsschwingungssignal ($V_L$) über den Induktivitäten (L1, L2) und eine Schaltfunktion ($\alpha_1$) für die Leistungshalbleiterschalter der Schaltzellen (3) des ersten Teilumrichtersystems (1) zugeführt ist,
das der zweiten Ansteuerschaltung (5) zur Bildung des weiteren Ansteuersignals (S2) ein Spannungsschwingungssignal ($V_L$) über den Induktivitäten (L1, L2) und eine Schaltfunktion ($\alpha_2$) für die Leistungshalbleiterschalter der Schaltzellen (3) des zweiten Teilumrichtersystems (2) zugeführt ist, und
**dass** eine erste Berechnungseinheit (6) zur Bildung der Schaltfunktionen ($\alpha_1$, $\alpha_2$) aus einem Spannungsschwingungssignal ($V_A$) bezüglich der Spannung ($V_u$) am Ausgangsanschluss (A) und einem wählbaren Referenzsignal ($V_{ref}$) vorgesehen ist.

11. Vorrichtung nach Anspruch 10, **dadurch gekennzeichnet, dass** eine zweite Berechnungseinheit (10) zur Bildung des Spannungsschwingungssignals ($V_L$) über den Induktivitäten (L1, L2) aus einem Stromschwingungssignal ($V_i$) der Teilumrichtersysteme (1, 2) vorgesehen ist.

12. Vorrichtung nach Anspruch 11, **dadurch gekennzeichnet, dass** eine dritte Berechnungseinheit (7) zur Bildung des Stromschwingungssignals ($V_i$) der Teilumrichtersysteme (1, 2) aus einem Stromschwingungssignalamplitudenwert ($A_h$) vorgesehen ist.

**13.** Vorrichtung nach Anspruch 12, **dadurch gekennzeichnet, dass** eine vierte Berechnungseinheit (9) zur Bildung des Stromschwingungssignalamplitudenwertes ($A_h$) aus dem Stromistwert ($i_u$) am Ausgangsanschluss (A) und dem Referenzsignal ($V_{ref}$) vorgesehen ist.

**14.** Vorrichtung nach Anspruch 13, **dadurch gekennzeichnet, dass** einen fünfte Berechnungseinheit (8) zur Bildung des Spannungsschwingungssignals ($V_A$) bezüglich der Spannung ($V_u$) am Ausgangsanschluss (A) aus einem Spannungsschwingungssignalamplitudenwert ($M_h$) vorgesehen ist.

**15.** Vorrichtung nach Anspruch 14, **dadurch gekennzeichnet, dass** die vierte Berechnungseinheit (9) zur Bildung des Spannungsschwingungssignalamplitudenwertes ($M_h$) aus dem Stromistwert ($i_u$) am Ausgangsanschluss (A) und dem Referenzsignal ($V_{ref}$) vorgesehen ist.

**Claims**

**1.** Method for operation of a converter circuit, wherein the converter circuit has a first and a second partial converter system (1), the partial converter systems (2) are connected in series to one another via two series-connected inductances (L1, L2), the junction point of the two series-connected inductances (L1, L2) forms an output connection (A), each partial converter system (1, 2) comprises at least one two-pole switching cell (3), and each switching cell (3) has two series-connected controllable bidirectional power semiconductor switches with a controlled unidirectional current flow direction, and a capacitive energy store which is connected in parallel with the series circuit formed by the power semiconductor switches in which the power semiconductor switches in the switching cells (3) of the first partial converter system (1) are controlled by means of a control signal (S1), and the power semiconductor switches in the switching cells (3) in the second partial converter system (2) are controlled by means of a further control signal (S2),
**characterized**
**in that** the control signal (S1) is formed from a voltage oscillation signal ($V_L$) across the inductances (L1, L2) and a switching function ($\alpha_1$) for the power semiconductor switches in the switching cells (3) of the first partial converter system (1),
**in that** the further control signal (S2) is formed from the voltage oscillation signal ($V_L$) across the inductances (L1, L2) and a switching function ($\alpha_2$) for the power semiconductor switches in the switching cells (3) of the second partial converter system (2), and in that the switching functions ($\alpha_1$, $\alpha_2$) are formed by means of a voltage oscillation signal ($V_A$) with respect to the voltage ($V_u$) at the output connection (A), and a selectable reference signal ($V_{ref}$).

**2.** Method according to Claim 1, **characterized in that** the voltage oscillation signal ($V_L$) across the inductances (L1, L2) is formed from a current oscillation signal ($V_i$) of the partial converter systems (1, 2).

**3.** Method according to Claim 2, **characterized in that** the current oscillation signal ($V_i$) of the partial converter systems (1, 2) is formed from a current oscillation signal amplitude value ($A_h$).

**4.** Method according to Claim 3, **characterized in that** the current oscillation signal amplitude value ($A_h$) is formed from the current actual value ($i_u$) at the output connection (A) and the reference signal ($V_{ref}$).

**5.** Method according to one of the preceding Claims 1 to 4, **characterized in that** the voltage oscillation signal ($V_A$) with respect to the voltage ($V_u$) at the output connection (A) is formed from a voltage oscillation signal amplitude value ($M_h$).

**6.** Method according to Claim 5, **characterized in that** the voltage oscillation signal amplitude value ($M_h$) is formed from the current actual value ($i_u$) at the output connection (A) and the reference signal ($V_{ref}$).

**7.** Method according to Claim 2, **characterized in that** the current oscillation signal ($V_i$) of the partial converter systems (1, 2), the voltage oscillation signal ($V_L$) across the inductances (L1, L2), and the voltage oscillation signal ($V_A$) with respect to the voltage ($V_u$) at the output connection (A) are at the same frequency.

**8.** Method according to Claim 2 or 7, **characterized in that** the current oscillation signal ($V_i$) of the partial converter systems (1, 2), the voltage oscillation signal ($V_L$) across the inductances (L1, L2), and the voltage oscillation signal ($V_A$) with respect to the voltage ($V_u$) at the output connection (A) have the same phase shift.

9. Method according to one of the preceding Claims 1 to 8, **characterized in that** a reference voltage signal with respect to the voltage ($V_u$) of the output connection (A) is selected as the reference signal ($V_{ref}$).

10. Apparatus for carrying out a method for operation of a converter circuit, wherein the converter circuit has a first and a second partial converter system (1), the partial converter systems (2) are connected in series to one another via two series-connected inductances (L1, L2), the junction point between the two series-connected inductances (L1, L2) forms an output connection (A), each partial converter system (1, 2) comprises at least one two-pole switching cell (3), and each switching cell (3) has two series-connected controllable bidirectional power semiconductor switches with a controlled unidirectional current flow direction, and has a capacitive energy store which is connected in parallel with the series circuit formed by the power semiconductor switches having a first control circuit (4) which is used to produce a control signal (S1) and is connected to the power semiconductor switches in the switching cells (3) of the first partial converter system (1), and having a second control circuit (5), which is used to produce a further control signal (S2) and is connected to the power semiconductor switches in the switching cells (3) of the second partial converter system (2) **characterized in that**, in order to form the control signal (S1), the first control signal (4) is supplied with a voltage oscillation signal ($V_L$) across the inductances (L1, L2) and with a switching function ($\alpha_1$) for the power semiconductor switches in the switching cells (3) of the first partial converter system (1),
in that, in order to form the further control signal (S2), the second control circuit (5) is supplied with a voltage oscillation signal ($V_L$) across the inductances (L1, L2) and with a switching function ($\alpha_2$) for the power semiconductor switches in the switching cells (3) of the second partial converter system (2), and
**in that** a first calculation unit (6) is provided in order to form the switching functions ($\alpha_1$, $\alpha_2$) from a voltage oscillation signal ($V_A$) with respect to the voltage ($V_u$) at the output connection (A) and a selectable reference signal ($V_{ref}$).

11. Apparatus according to Claim 10, **characterized in that** a second calculation unit (10) is provided in order to form the voltage oscillation signal ($V_L$) across the inductances (L1, L2) from a current oscillation signal ($V_i$) of the partial converter systems (1, 2).

12. Apparatus according to Claim 11, **characterized in that** a third calculation unit (7) is provided in order to form the current oscillation signal ($V_i$) of the partial converter systems (1, 2) from a current oscillation signal amplitude value ($A_h$).

13. Apparatus according to Claim 12, **characterized in that** a fourth calculation unit (9) is provided in order to form the current oscillation signal amplitude value ($A_h$) from the current actual value ($i_u$) of the output connection (A) and the reference signal ($V_{ref}$).

14. Apparatus according to Claim 13, **characterized in that** a fifth calculation unit (8) is provided in order to form the voltage oscillation signal ($V_A$) with respect to the voltage ($V_u$) of the output connection (A) from a voltage oscillation signal amplitude value ($M_h$).

15. Apparatus according to Claim 14, **characterized in that** the fourth calculation unit (9) is provided in order to form the voltage oscillation signal amplitude value ($M_h$) from the current actual value ($i_u$) at the output connection (A) and the reference signal ($V_{ref}$).

**Revendications**

1. Procédé de gestion d'un circuit convertisseur, le circuit convertisseur présentant un premier et un deuxième système convertisseur partiel (1), les systèmes convertisseurs partiels (2) étant reliés l'un à l'autre en série par deux inductances (L1, L2) raccordées en série, le point de raccordement des deux inductances (L1, L2) raccordées en série formant une borne de sortie (A), chaque système convertisseur partiel (1, 2) comprenant au moins une cellule de commutation (3) bipolaire et chaque cellule de commutation (3) présentant deux commutateurs bidirectionnels semi-conducteurs de puissance asservis raccordés en série à direction unidirectionnelle asservie de passage du courant et un accumulateur capacitif d'énergie raccordé en parallèle au circuit série formé par les commutateurs semi-conducteurs de puissance,
dans lequel les commutateurs semi-conducteurs de puissance des cellules de commutation (3) du premier système convertisseur partiel (1) sont commandés au moyen d'un signal de commande (S1) et les commutateurs semi-conducteurs de puissance des cellules de commutation (3) du deuxième système convertisseur partiel (2) au moyen d'un autre signal de commande (S2),

**caractérisé en ce que**
le signal de commande (S1) est formé d'un signal oscillant de tension ($V_L$) aux bornes des inductances (L1, L2) et d'une fonction de commutation ($\alpha_1$) des commutateurs semi-conducteurs de puissance des cellules de commutation (3) du premier système convertisseur partiel (1),

**en ce que** l'autre signal de commande (S2) est formé du signal oscillant de tension ($V_L$) aux bornes des inductances (L1, L2) et d'une fonction de commutation ($\alpha_2$) des commutateurs semi-conducteurs de puissance des cellules de commutation (3) du deuxième système convertisseur partiel (2) et

**en ce que** les fonctions de commutation ($\alpha_1$, $\alpha_2$) sont formées au moyen d'un signal oscillant de tension ($V_A$) qui oscille par rapport à la tension ($V_u$) à la borne de sortie (A) et au moyen d'un signal de référence ($V_{ref}$) pouvant être sélectionné.

2. Procédé selon la revendication 1, **caractérisé en ce que** le signal oscillant de tension ($V_L$) aux bornes des inductances (L1, L2) est formé par un signal oscillant de courant ($V_i$) des systèmes convertisseurs partiels (1, 2).

3. Procédé selon la revendication 2, **caractérisé en ce que** le signal oscillant de courant ($V_i$) des systèmes convertisseurs partiels (1, 2) est formé d'une valeur d'amplitude ($A_h$) du signal oscillant de courant.

4. Procédé selon la revendication 3, **caractérisé en ce que** la valeur ($A_h$) d'amplitude du signal oscillant de courant est formée de la valeur effective ($i_u$) du courant à la borne de sortie (A) et du signal de référence ($V_{ref}$).

5. Procédé selon l'une des revendications 1 à 4 qui précèdent, **caractérisé en ce que** le signal oscillant de tension ($V_A$) est formé d'une valeur ($M_h$) d'amplitude du signal oscillant de tension par rapport à la tension ($V_u$) sur la borne de sortie (A).

6. Procédé selon la revendication 5, **caractérisé en ce que** la valeur ($M_h$) d'amplitude du signal oscillant de tension est formée de la valeur ($i_u$) effective du courant à la borne de sortie (A) et du signal de référence ($V_{ref}$).

7. Procédé selon la revendication 2, **caractérisé en ce que** le signal oscillant de courant ($V_i$) des systèmes convertisseurs partiels (1, 2), le signal oscillant de tension ($V_L$) aux bornes des inductances (L1, L2) et le signal oscillant de tension ($V_A$) qui oscille par rapport à la tension ($V_u$) à la borne de sortie (A) ont la même fréquence.

8. Procédé selon la revendication 2 ou 7, **caractérisé en ce que** le signal oscillant de courant ($V_i$) des systèmes convertisseurs partiels (1, 2), le signal oscillant de tension ($V_L$) aux bornes des inductances (L1, L2) et le signal oscillant de tension ($V_A$) qui oscille par rapport à la tension ($V_u$) à la borne de sortie (A) ont le même déphasage.

9. Procédé selon l'une des revendications 1 à 8 qui précèdent, **caractérisé en ce qu'**un signal de tension de référence par rapport à la tension ($V_u$) à la borne de sortie (A) est sélectionné comme signal de référence ($V_{ref}$).

10. Dispositif en vue de l'exécution d'un procédé de gestion d'un circuit convertisseur, le circuit convertisseur présentant un premier et un deuxième système convertisseur partiel (1), les systèmes convertisseurs partiels (2) étant reliés l'un à l'autre en série par deux inductances (L1, L2) raccordées en série, le point de raccordement des deux inductances (L1, L2) raccordées en série formant une borne de sortie (A), chaque système convertisseur partiel (1, 2) comprenant au moins une cellule de commutation (3) bipolaire et chaque cellule de commutation (3) présentant deux commutateurs bidirectionnels semi-conducteurs de puissance asservis raccordés en série à direction unidirectionnelle asservie de passage du courant et un accumulateur capacitif d'énergie raccordé en parallèle au circuit série formé par les commutateurs semi-conducteurs de puissance,
un premier circuit de commande (4) qui sert à former un signal de commande (S1), le premier circuit de commande (4) étant relié aux commutateurs semi-conducteurs de puissance des cellules de commutation (3) du premier système convertisseur partiel (1), et
un deuxième circuit de commande (5) qui sert à former un autre signal de commande (S2), le deuxième circuit de commande (5) étant relié aux commutateurs semi-conducteurs de puissance des cellules de commutation (3) du deuxième système convertisseur partiel (2),
**caractérisé en ce que**
pour former le signal de commande (S1), un signal oscillant de tension ($V_L$) aux bornes des inductances (L1, L2) et une fonction de commutation ($\alpha_1$) des commutateurs semi-conducteurs de puissance des cellules de commutation (3) du premier système convertisseur partiel (1) sont amenés au premier circuit de commande (4),
pour former l'autre signal de commande (S2), un signal oscillant de tension ($V_L$) aux bornes des inductances (L1, L2) et une fonction de commutation ($\alpha_2$) des commutateurs semi-conducteurs de puissance des cellules de commutation (3) du deuxième système convertisseur partiel (2) sont amenés au deuxième circuit de commande (5) et **en ce qu'**une première unité de calcul (6) est prévue pour former les fonctions de commutation ($\alpha_1$, $\alpha_2$) à partir d'un signal oscillant de tension ($V_A$) qui oscille par rapport à la tension ($V_u$) à la borne de sortie (A) et d'un signal de référence ($V_{ref}$) pouvant être sélectionné.

11. Dispositif selon la revendication 10, **caractérisé en ce qu'**une deuxième unité de calcul (10) est prévue pour former le signal oscillant de tension ($V_L$) aux bornes des inductances (L1, L2) à partir d'un signal oscillant de courant ($V_i$) des systèmes convertisseurs partiels (1, 2).

12. Dispositif selon la revendication 11, **caractérisé en ce qu'**une troisième unité de calcul (7) est prévue pour former le signal oscillant de courant ($V_i$) des systèmes convertisseurs partiels (1, 2) à partir d'une valeur ($A_h$) d'amplitude du signal oscillant de courant.

13. Dispositif selon la revendication 12, **caractérisé en ce qu'**une quatrième unité de calcul (9) est prévue pour former la valeur ($A_h$) d'amplitude du signal oscillant de courant à partir de la valeur effective ($i_u$) du courant à la borne de sortie (A) et du signal de référence ($V_{ref}$).

14. Dispositif selon la revendication 13, **caractérisé en ce qu'**une cinquième unité de calcul (8) est prévue pour former le signal oscillant de tension ($V_A$) qui oscille par rapport à la tension ($V_u$) à la borne de sortie (A) à partir d'une valeur ($M_h$) d'amplitude du signal oscillant de tension.

15. Dispositif selon la revendication 14, **caractérisé en ce que** la quatrième unité de calcul (9) est prévue pour former la valeur ($M_h$) d'amplitude du signal oscillant de tension à partir de la valeur effective du courant ($i_u$) à la borne de sortie (A) et du signal de référence ($V_{ref}$).

Stand der Technik

**Fig. 1**

Fig. 2

**Fig. 3**

**Fig. 4**

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2007023064 A1

- US 5070440 A1